Europäisches Patentamt

European Patent Office

Office européen des brevets

(11) Veröffentlichungsnummer: **0 209 187**
**A2**

(12) **EUROPÄISCHE PATENTANMELDUNG**

(21) Anmeldenummer: 86201193.9

(22) Anmeldetag: 08.07.86

(51) Int. Cl.⁴: **G01N 24/08**

(30) Priorität: 11.07.85 DE 3524682

(43) Veröffentlichungstag der Anmeldung:
21.01.87 Patentblatt 87/04

(84) Benannte Vertragsstaaten:
**DE FR GB IT NL**

(71) Anmelder: **Philips Patentverwaltung GmbH**
**Billstrasse 80**
**D-2000 Hamburg 28(DE)**
Anmelder: **N.V. Philips' Gloeilampenfabrieken**
**Groenewoudseweg 1**
**NL-5621 BA Eindhoven(NL)**

(72) Erfinder: **Kuhn, Michael Harald, Dr.**
**Süntelstrasse 77**
**D-2000 Hamburg 61(DE)**
Erfinder: **Kunz, Dietmar Wilhelm, Dr.**
**Boxholmstrasse 9**
**D-2085 Quickborn(DE)**

(74) Vertreter: **Hartmann, Heinrich, Dipl.-Ing. et al**
**Philips Patentverwaltung GmbH Billstrasse**
**80 Postfach 10 51 49**
**D-2000 Hamburg 28(DE)**

(54) **Kernspinuntersuchungsverfahren.**

(57) Die Erfindung betrifft ein Kernspinuntersuchungsverfahren zur selektiven Anregung eines begrenzten Volumens eines zu untersuchenden Körpers, bei dem die Anregung mit drei aufeinanderfolgenden frequenzmodulierten Impulsen erfolgt, von denen der erste und der dritte einander gleich und der zweite ein 180°-Impuls ist. Während jedes der drei Impulse ist ein magnetisches Gradientenfeld wirksam, dessen Gradient jeweils in einer von drei senkrecht zueinander stehenden Richtungen verläuft.

FIG.3a

FIG.3b

FIG.3c

FIG.3d

## Kernspinuntersuchungsverfahren

Die Erfindung betrifft ein Kernspinuntersuchungsverfahren zur selektiven Anregung eines begrenzten Volumens eines zu untersuchenden Körpers, bei dem der Körper einem homogenen stationären Magnetfeld, drei Sequenzen eines senkrecht zum stationären Magnetfeld verlaufenden Hochfrequenz-Magnetfeldes und während wenigstens einer der drei Sequenzen einem in Richtung des stationären Magnetfeldes verlaufenden Gradienten-Magnetfeld ausgesetzt ist.

Ein solches Verfahren zur selektiven Anregung eines Teilvolumens eines zu untersuchenden Körpers ist aus J. Mag. Res. 56, 350-354 (1984) bekannt. Es kann bei Untersuchungen verwendet werden, bei denen es darauf ankommt, Information nur aus dem Teilvolumen zu gewinnen, z.B. bei den Untersuchungen von im Körperinneren eines Patienten liegenden Organen. Bei dem bekannten Verfahren besteht jede der drei Sequenzen aus drei amplitudenmodulierten Hochfrequenzimpulsen, von denen der erste und der dritte schmalbandige 45°-Impulse sind und der zweite ein breitbandiger 90°-Impuls ist. Während jeder Sequenz wirkt ein Gradienten-Magnetfeld, wobei die Gradienten der drei während der drei Sequenzen wirksamen Magnetfelder in zueinander senkrecht stehenden Richtungen verlaufen. Nach der Anregung ist gegenüber dem Zustand vor der Verabfolgung der Sequenzen die Kernmagnetisierung im Innern des anzuregenden Teilvolumens um 180° verschoben. Außerhalb des Volumens beträgt die Verschiebung nur 90°, und sie dephasiert dort unter dem Einfluß von Inhomogenitäten des stationären Feldes - schnell, so daß dieser Bereich in einem anschließend auszuführenden Meßverfahren keinen Einfluß auf die dabei erzeugten Meßsignale hat.

Ein Nachteil des bekannten Verfahrens besteht jedoch darin, daß der 90°-Impuls weder ortsabhängige Flipwinkel (der Flipwinkel ist der Winkel, den der Kernmagnetisierungsvektor mit der Richtung des stationären Magnetfeldes einschließt) noch ortsabhängige Phasen erzeugen darf, da anderenfalls Störsignale aus Bereichen außerhalb des anzuregenden Volumens erzeugt werden. Dies wird im allgemeinen dadurch erreicht, daß ein solcher Impuls amplitudenmoduliert und so breitbandig ist, daß sein Spektrum den ganzen zu untersuchenden Bereich trotz anwesender Gradientenfelder überdeckt. Während dies in kleinem Maßstab möglich ist, führt bei großen zu untersuchenden Volumina, z.B. bei der Untersuchung eines menschlichen Körpers, die benötigte Hochfrequenzspitzenleistung zu kaum zu erfüllenden Anforderungen an den Hochfrequenz-Leistungsverstärker.

Es ist Aufgabe der vorliegenden Erfindung, ein Verfahren anzugeben, das ebenfalls die Anregung eines begrenzten Volumens dadurch ermöglicht, daß die Kernmagnetisierung im Innern dieses Volumens erhalten bzw. invertiert und außerhalb des Volumens dephasiert wird, bei dem sich jedoch geringere Anforderungen an den Hochfrequenz-Leistungsverstärker ergeben.

Ausgehend von einem Verfahren der eingangs genannten Art wird diese Aufgabe erfindungsgemäß dadurch gelöst, daß die erste Sequenz aus einem ersten Impuls besteht, der die Kernmagnetisierung um zumindest annähernd 90° kippt, daß die zweite Sequenz aus einem 180°-Impuls besteht, daß die dritte Sequenz aus einem dritten Impuls besteht, der die Kernmagnetisierung um den gleichen Winkel kippt wie der erste Impuls und dessen Phasenlage so gewählt ist, daß in dem zu selektierenden Volumen die Kernmanetisierung in die Richtung des statischen Feldes oder in die Gegen richtung gekippt wird, daß wenigstens der Impuls, währenddessen das Gradientenfeld wirksam ist, frequenzmoduliert ist und daß die Mitte des zweiten Impulses von den Mitten des ersten und des dritten Impulses jeweils den gleichen zeitlichen Abstand hat.

Zur Durchführung des Verfahrens wird ausgegangen von einer Anordnung mit einem Magneten zur Erzeugung eines statischen homogenen Magnetfeldes, drei Spulenanordnungen zur Erzeugung von Gradienten-Magnetfeldern, die in Richtung des statischen Magnetfeldes verlaufen und deren Gradienten in drei zueinander senkrehten Richtungen verlaufen, und mit einer Hochfrequenzspule zur Erzeugung von Hochfrequenz-Magnetfeldern, die zur Richtung des statischen Magnetfeldes senkrecht verlaufen, sowie mit Steuermitteln zum Aktivieren der Spulenanordnungen und der Hochfrequenz-Spulenanordnung; erfindungsgemäß ist vorgesehen, daß mit der Hochfrequenz-Spulenanordnung ein FM-Modulator gekoppelt ist und daß die Steuereinrichtung die Hochfrequenz-Spulenanordnung und wenigstens eine der drei Spulenanordnungen so steuert, daß während wenigstens eines jeden Hochfrequenzimpulses eine andere der drei Spulenanordnungen wirksam ist.

Bei der Erfindung wird durch den ersten Impuls die Magnetisierung um 90° gekippt. Der Magnetisierungsvektor befindet sich dann in der xy-Ebene eines kartesischen Koordinatensystems, dessen z-Richtung mit der Richtung des statischen Magnetfeldes zusammenfällt und dessen Koordinatenursprung ein Punkt ist, in dem nur das statische Magnetfeld, nicht aber die magnetischen Gradientenfelder vorhanden sind. Durch den anschließenden 180°-Impuls wird der Magnetisierungsvektor, der sich in der xy-Ebene eines mit der Larmorfrequenz um die z-Achse rotierenden Koordinatensystems befindet, um eine Achse in gespiegelt. Der Magnetisierungsvektor liegt in dem rotierenden Koordinatensystem womit wiederum in der xy-Ebene, wobei seine Lage gegenüber der Lage vor dem zweiten Impuls jedoch um 0° bis 180° gedreht sein kann. Der dritte Impuls ist mit dem ersten Impuls identisch, was seine Amplitude und seinen zeitlichen Verlauf betrifft. Der Effekt dieses dritten Impulses, durch den die Kernmagnetisierung um 90° gekippt werden kann, hängt davon ab, welcher Winkel in dem rotierenden Koordinatensystem zwischen dem Kernmagnetisierungsvektor an den verschiedenen Stellen des Untersuchungsbereiches einerseits und der mit dem Koordinatensystem mitrotierenden Komponente des dritten Hochfrequenzimpulses besteht. In Abhängigkeit von diesem Winkel können die Spins wieder in Richtung des Hauptfeldes, d.h. in + oder in -z-Richtung gebracht werden, was eine spätere Anregung durch einen Hochfrequenzimpuls erlaubt, oder sie können in der x-y-Ebene belassen werden, was zu einer raschen Dephasierung und dazu führt, daß diese Spins nicht mehr zu einem detektierbaren Signal beitragen können. Ändert sich der Phasenwinkel zwischen dem Hochfrequenzimpuls und den Spins schnell als Funktion des Ortes, so führt dies ebenfalls zu einer Dephasierung und damit zum Verschwinden des Signals. Deshalb stehen für nachfolgende Anregungen nur solche Spins zur Verführung für die

a) der Phasenwinkel zwischen dem dritten Hochfrequenzimpuls und den Spins als Funktion aller drei Raumrichtungen zumindest annähernd konstant ist und

b) dieser Phasenwinkel so gewählt ist, daß die Spins nach dem Puls parallel oder antiparallel zur Richtung des Hauptfeldes stehen.

Das Teilvolumen in dem diese Bedingungen erfüllt sind, ergibt sich dadurch, daß während wenigstens eines Hochfrequenzimpulses ein magnetisches Gradientenfeld wirksam ist und daß wenigstens dieser Hochfrequenzimpuls frequenzmoduliert ist, vorzugsweise linear frequenzmoduliert. Wirkt nämlich während eines linear frequenzmodulierten Hochfrequenzimpulses ein magnetisches Gradientenfeld, dann führt dies dazu, daß der Winkel, den die Kernspins in der xy-Ebene mit dem rotierenden Koordinatensystem einschließen, sich als Funktion der Richtung des Gradienten dieses Feldes parabelförmig ändert. Nur die Bereiche im Scheitel dieser (quadratischen) Parabel können die Bedingung a) erfüllen.

Wirkt nur während eines einzigen frequenzmodulierten Hochfrequenzimpulses ein Gradientenfeld, dann kann mit dem erfindungsgemäßen Verfahren eine Scheibe selektiert werden (im Innern dieser Scheibe sind die Kernspins also im wesentlichen parallel zur Richtung des Magnetfeldes oder antiparallel dazu ausgerichtet, während sie außerhalb der Scheibe dephasiert sind), die sich senkrecht zur Richtung des Gradienten des Magnetfeldes erstrecken und deren Dicke um so größer ist, je - schneller sich die Momentanfrequenz des frequenzmodulierten Hochfrequenzimpulses ändert und je niedriger der Gradient dieses Magnetfeldes ist.

Läßt man während jedes der drei Hochfrequenzimpulse ein magnetisches Gradientenfeld wirken, wobei die Richtungen der Gradienten dieser Felder senkrecht aufeinanderstehen, dann kann ein allseits begrenztes Volumen selektiert werden.

Da es möglich ist, frequenzmodulierte Impulse mit hoher Bandbreite und niedriger Spitzenleistung zu erzeugen, kann man bei diesem Verfahren auch relativ hohe Gradientenfelder verwenden. Das erlaubt eine genaue Festlegung des anzuregenden Volumens. Darüber hinaus hat die Frequenz modulation der Hochfrequenzimpulse gegenüber der Amplitudenmodulation den Vorteil, daß die Hochfrequenzspitzenleistung wesentlich kleiner sein kann.

Eine Weiterbildung der Erfindung sieht vor, daß zwischen dem ersten und dem zweiten oder dem zweiten und dem dritten Impuls wenigstens ein magnetisches Gradientenfeld wirksam ist. Durch ein zwischen den Hochfrequenzimpulsen wirksames Gradientenfeld wird der Winkel der Kernspins in dem rotierenden Koordinatensystem in Richtung des Gradienten linear als Funktion des Ortes geändert. Dadurch verschiebt sich der Bereich, in dem die Bedingung a) erfüllt ist in der Richtung des Gradienten oder in Gegenrichtung. Das bedeutet also, daß durch diese Ausgestaltung die Lage des selektierten Bereiches verändert werden kann. Macht man die Größe dieser Gradientenfelder einstellbar, dann kann die Lage des selektierten Bereiches den diagnostischen Forderungen angepaßt werden.

Die Erfindung wird nahstehend anhand der Zeichnung näher beschrieben. Es zeigen:

Fig. 1 ein Kernspinuntersuchungsgerät, bei dem die Erfindung anwendbar ist,

Fig. 2 ein Blockschaltbild einer Einrichtung zur Erzeugung der bei der Anordnung nach Fig. 1 erforderlichen Hochfrequenzimpulse und der Gradientenfelder,

Fig. 3 den zeitlichen Verlauf der Hochfrequenzimpulse und der Gradientenfelder in den verschiedenen Koordinatenrichtungen und

Fig. 4 den räumlichen Verlauf des Winkels, den die Kernspins mit dem rotierenden Koordinatensystem in verschiedenen Untersuchungsphasen einschließen.

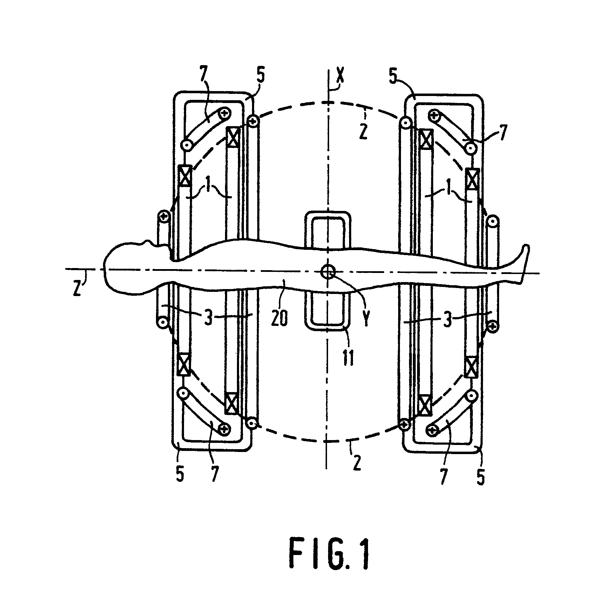

Das in Fig. 1 schematisch dargestellte Kernspinuntersuchungsgerät, ein sogenannter Kernspintomograph, enthält eine aus vier Spulen 1 bestehende Anordnung zur Erzeugung eines homogenen statischen Magnetfeldes von beispielsweise 2T. Die zur z-Achse konzentrisch angeordneten Spulen können auf einer Kugeloberfläche 2 angeordnet sein.

Zur Erzeugung eines in z-Richtung verlaufenden Gradienten-Magnetfeldes, dessen Gradient ebenfalls in z-Richtung verläuft, sind vier Spulen 3 vorzugsweise auf der gleichen Kugeloberfläche angeordnet. Das in z-Richtung verlaufende Gradientenfeld, dessen Feldstärke sich in y-Richtung, d.h. senkrecht zur Zeichenebene ändert, wird von vier Spulen 5 erzeugt, von denen in Fig. 1 nur zwei dargestellt sind. Das in z-Richtung verlaufende Magnetfeld mit einem Gradienten in x-Richtung wird durch vier Spulen 7 erzeugt, die mit den Spulen 5 identisch sein können, die jedoch diesen gegenüber um 90° versetzt angeordnet sind. Da jede der drei Spulenanordnungen 3, 5 und 7 zur Erzeugung der magnetischen Gradientenfelder symmetrisch zur Kugeloberfläche 2 angeordnet ist, ist die magnetische Feldstärke im Zentrum der Kugel, das gleichzeitig den Koordinatenursprung eines kartesischen x-, y-, z-Koordinatensystem bildet, nur durch das statische homogene Magnetfeld der Spule 1 bestimmt.

Weiterhin ist eine Hochfrequenzspule 11 symmetrisch zur Ebene z = 0 des Koordinatensystems angeordnet, die so ausgebildet ist, daß damit ein im wesentlichen homogenes in x-Richtung (d.h. senkrecht zur Richtung des statischen homogenen Magnetfeldes) verlaufendes Hochfrequenzfeld erzeugt wird. Der Hochfrequenzspule 11 wird während jedes Hochfrequenzimpulses ein hochfrequenter frequenzmodulierter Strom von einem Verstärker 31 zugeführt.

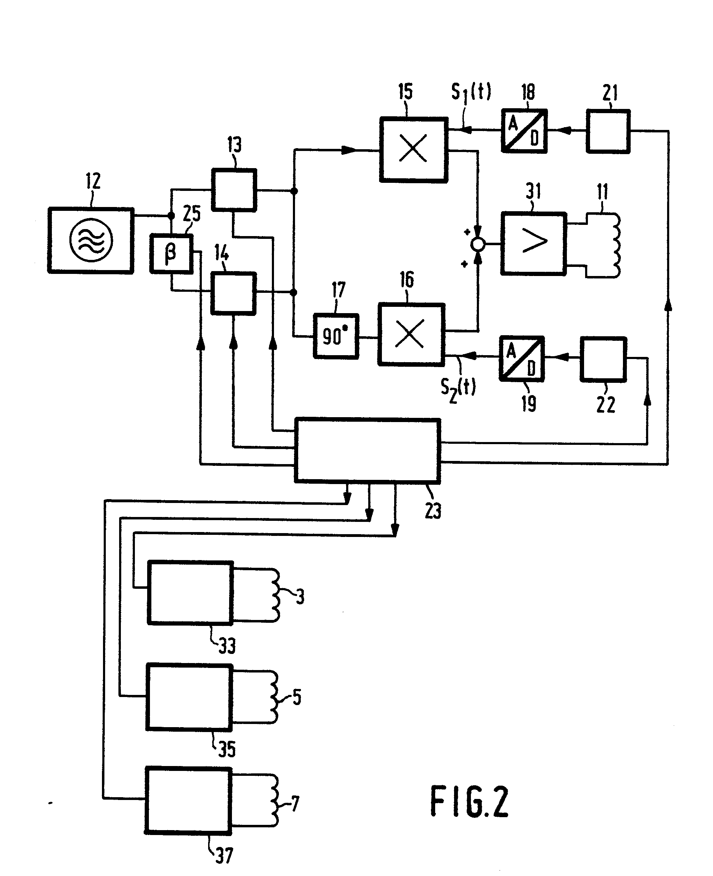

Die in Fig. 2 dargestellte Schaltung zur Erzeugung dieses Stromes umfaßt einen Hochfrequenzoszillator 12, der an seinem Ausgang ein Oszillatorsignal liefert, dessen Frequenz exakt der Larmorfrequenz entspricht, die ihrerseits der Stärke des statischen homogenen Magnetfeldes proportional ist. Der Ausgang ist über steuerbare Torschaltungen 13, 14, von denen -durch eine Steuereinrichtung 23 gesteuert -immer nur eine das Signal durchläßt, mit einem Quadraturkreis verbunden, wobei in Reihe mit der Torschaltung 14 ein Phasendrehglied 25 mit durch die Steuereinrichtung 23 gesteuerter Phasenlage vorgesehen ist. Der Quadraturkreis enthält in seinem einen Zweig einen Mischer 15 und in seinem anderen Zweig die Serienschaltung eines 90°-Phasendrehgliedes und eines Mischers 16, wobei die Ausgangssignale der Mischer 15 und 16 addiert und dem Verstärker 31 zugeführt werden. Das -gegebenenfalls phasenverschobene -Signal wird in den Mischstufen 15 und 16 mit je einem Hüllkurvensignal ($s_1(t)$ bzw. $s_2(t)$) multipliziert, das aus einem Speicher 21 bzw. 22 über einen Digital-Analog-Wandler 18 bzw. 19 zugeführt wird und den Realteil bzw. den Imaginärteil eines komplexen Hüllkurvensignals darstellt. Diese Signale sind so gewählt, daß sich als Summe der Oszillatorsignale ein Signal ergibt, das einer frequenzmodulierten Schwingung mit einer sich im wesentlichen zeitlich linear ändernden Frequenz entspricht. Die in den Speichern 21, 22 als Folge von Stützstellen gespeicherten Hüllkurvensignale können mittels eines nicht näher dargestellten Computers auf folgende Weise berechnet werden:

a) Es wird zunächst die zeitliche Änderung a der Kreisfrequenz in dem frequenzmodulierten Signal nach der Gleichung

$$a = 1 \bullet \gamma \cdot G/T_0 \quad (1)$$

bestimmt. Dabei ist 1 eine Strecke, die groß ist im Vergleich zu den Abmessungen des anzuregenden Volumens (in der Richtung des jeweils angelegten Gradientenfeldes), $\gamma$ das gyromagnetische Verhältnis (für Protonen ca. 42,5 MHz/T), G der Gradient des während des frequenzmodulierten Impulses anliegenden magnetischen Gradientenfeldes und $T_0$ die Zeitdauer des Hochfrequenzimpulses. Je größer die Impulsdauer gewählt wird, um so niedriger ist die erforderliche Spitzenleistung; jedoch macht sich bei einer zu langen Impulsdauer der Einfluß der T1-und T2-Relaxationszeiten bemerkbar.

b) Die frequenzmodulierte Zeitfunktion $s_0(t)$, für die die Gleichung

$$s_i 0(t) = \exp(-iat^2/2) \quad (2)$$

gilt, wird in den komplexen Frequenzbereich Fouriertransformiert. Dabei ist $i = (-1)^{1/2}$

c) Das so fouriertransformierte komplexe Signal wird mit einer komplexen Spektralfunktion f(w) multipliziert, die der Bedingung genügt

$$f(w) = \begin{cases} 1 \text{ für } /w-w_0/ \leq \Delta w \\[2em] \exp\left(-0,5(/w-w_0/-\Delta w^2)/(b^2 \text{ für } /w-w_0/ \geq \Delta w \right) \end{cases} \tag{3}$$

Dabei ist w die (variable) Kreisfrequenz $w_0$ die Larmor-Kreisfrequenz, b ein die Steilheit der Spektralfunktion bestimmender Faktor und $\Delta w$ die Bandbreite des Zeitsignals, für das die Beziehung gilt

$$w = aT_0 \tag{4}$$

Je kleiner b ist, desto reckteckiger ist der Verlauf des Frequenzspektrums des frequenzmodulierten Impulses. Ein geeigneter Wert liegt b = 500$\pi$/sec (bei einer Bandbreite von 10 kHz).

d) Das so gebildete Produkt wird in den Zeitbereich rücktransformiert. Das resultierende komplexe Zeitsignal hat die Form

$$s(t) = s_1(t) + is_2(t), \tag{5}$$

wobei $s_1(t)$ der Realteil und $s_2(t)$ der Imaginärteil des Zeitsignals ist. Die auf diese Weise ermittelten Signale $s_1(t)$ und $s_2(t)$ sind die Hüllkurvensignale, die für eine Reihe von Stützstellen berechnet und in den Speichern 21 und 22 abgelegt wird. Am Eingang des Verstärkers 31 erscheint somit ein Signal u(t), das der Beziehung

$$u(t) = s_1(t)\cos w_0 t + s_2(t)\sin w_0 t \tag{6}$$

genügt, wobei das Vorzeichen des zweiten Summanden davon abhängt, ob das Signal am Eingang des Gliedes 17 dem Signal an dessen Ausgang um 90° nach-oder voreilt.

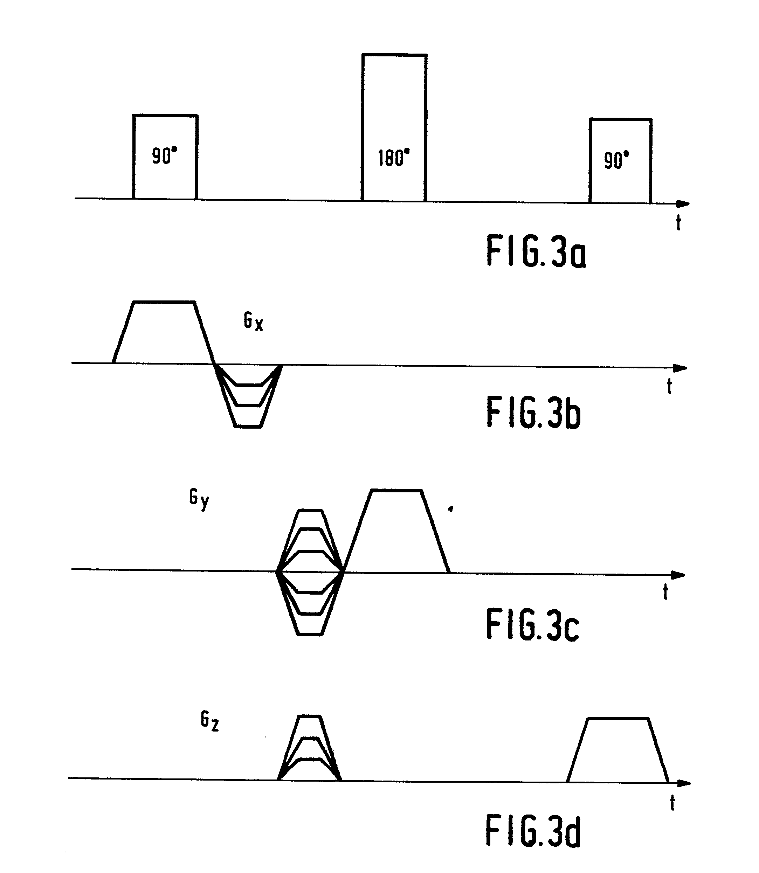

Während des auf diese Weise erzeugten ersten Hochfrequenzimpulses, der den Magnetisierungsvektor um 90° kippt, wird der Spulenanordnung 7 über einen Verstärker 37, der von der Steuereinrichtung 23 gesteuert wird, ein Strom zugeführt, so daß diese Spule ein magnetisches Gradientenfeld erzeugt, dessen Gradient in x-Richtung wirksam ist. Der zeitliche Verlauf dieses Gradientent $G_x$ ist in Fig 3b dargestellt, während der zeitliche Verlauf des Hochfrequenzimpulses aus Fig. 3a hervorgeht.

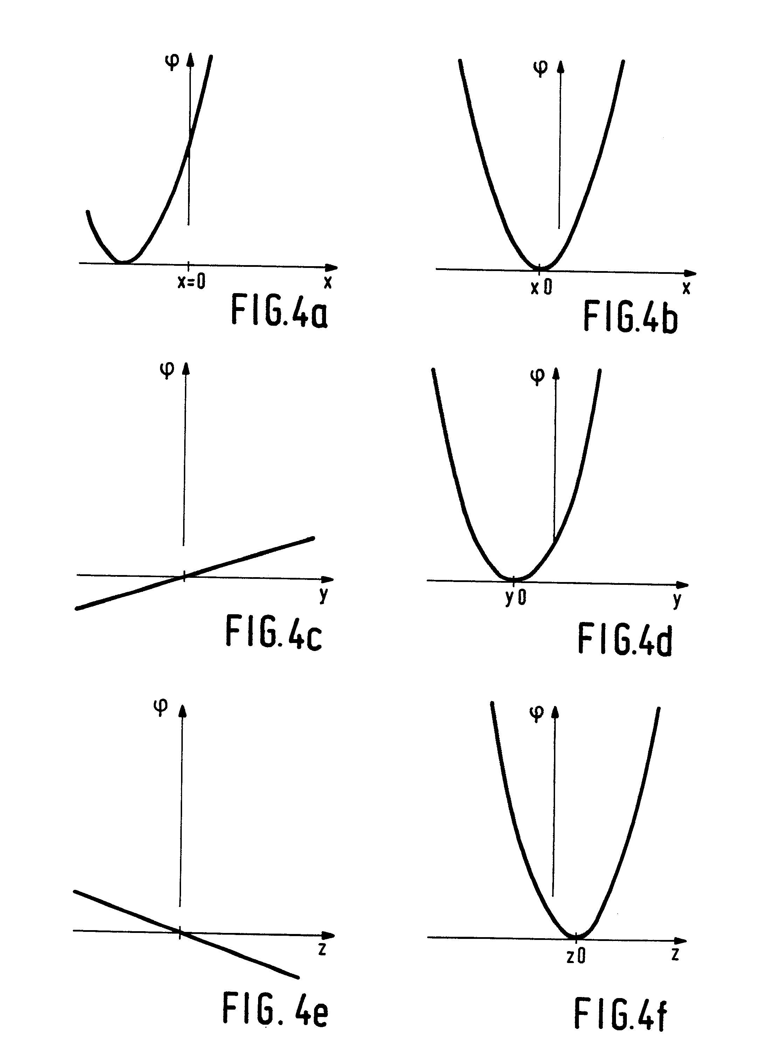

Das magnetische Gradientenfeld bewirkt, daß die in die x-y-Ebene gekippten Kernspins in der xy-Ebene einen Phasenwinkel aufweisen, der sich in x-Richtung parabelförmig ändert. Dies ist in Fig. 4a dargestellt, die diesen Phasenwinkel als Funktion der x-Koordinate zeigt. Man erkennt, daß der Scheitel der die Abhängigkeit des Phasenwinkels darstellenden Parabel nicht in der Ebene x = 0 des kartesischen Koordinatensystems liegt, sondern außerhalb. Da nur im Bereich dieses Scheitels der Phasenwinkel eine geringe Ortsabhängigkeit aufweist und da nur der durch diesen Scheitel festgelegte Raumbereich durch das erfindungsgemäße Verfahren selektiert werden kann, kann es erforderlich werden, diesen Bereich in x-Richtung zu verschieben. Diese Verschiebung erfolgt dadurch, daß nach dem ersten Hochfrequenzimpuls und vor dem zweiten Hochfrequenzimpuls ein magnetisches Gradientenfeld mit in x-Richtung verlaufendem Gradienten eingeschaltet wird. Durch diesen außerhalb der Hochfrequenzimpulse wirksamen Gradienten erfahren die Kernspins gegenüber dem rotierenden Koordinatensystem eine Phasenverschiebung, die linear von der x-Koordinate abhängt. Da sich aus der Überlagerung der parabelförmigen Ortsabhängigkeit des Phasenwinkels (während eines frequenzmodulierten Impulses) und aus der linearen Ortsabhängigkeit des Phasenwinkels wiederum eine parabelförmige Abhängigkeit, jedoch mit in x-Richtung versetztem Scheitelpunkt ergibt, führt dies zu einer Verschiebung des Scheitels bis zur Koordinate x = x0. Damit diese Verschiebung in Richtung auf den Koordinatenursprung erfolgt, muß der Gradient nach dem Hochfrequenzimpuls die entgegengesetzte Polarität haben wie während des Hochfrequenzimpulses. Je größer der Gradient ist, desto größer ist auch die Verschiebung.

Nach dem ersten und vor dem zweiten Hochfrequenzimpuls können auch die Gradientenspulenanordnungen 3 und 5 über von der Steuereinrichtung 23 gesteuerte Verstärker 33 und 35 erregt werden, so daß magnetische Gradientenfelder mit einem Gradienten Gy in x-Richtung bzw. einem Gradienten Gz in z-Richtung erzeugt werden. Durch diese Gradientenfelder ergibt sich in y-und z-Richtung eine lineare Abhängigkeit des Phasenwinkels, die auf die Lage des angeregten Volumens Einfluß hat. Die sich hieraus ergebende Abhängigkeit des Phasenwinkels in y-und z-Richtung ist in den Fig. 4c und 4e dargestellt.

Durch den zweiten Hochfrequenzimpuls, der ein 180° Impuls ist, der also so gewählt ist, daß - würde er als erster zugeführt -die Kernmagnetisierung aus der Richtung des statischen Magnetfeldes in die entgegengesetzte Richtung gekippt werden könnte, wird der Phasenwinkel der Kernspins in dem rotierenden Koordinatensystem um eine Achse gespiegelt, die durch die räumliche Lage der mit dem rotierenden Koordinatensystem mitrotierenden Komponente des Hochfrequenz-Magnetfeldes in bezug auf dieses Koordinatensystem gegeben ist. Da während dieses zweiten Impulses ein magnetisches Gradientenfeld mit einem Gradienten in y-Richtung wirksam ist, ergibt sich eine parabelförmige Abhängigkeit des Phasenwinkels in y-Richtung, deren Scheitelpunkt außerhalb der Ebene y = 0 liegt (an der Stelle y0), wenn schon vor dem zweiten Impuls ein Gradientenfeld in y-Richtung wirksam war. Der Abstand des Scheitelpunktes von der Ebene y = 0 ist dabei desto größer, je größer der Gradient in y-Richtung vor dem zweiten Impuls war und je länger er wirksam war.

Zur Erzeugung des 180°-Impulses werden in den Speicher 21 und 22 die Hüllkurvensignale $s_1$ und $s_2$ geladen, die für einen solchen Impuls ausgelegt sind. Falls die Speicherkapazität genügend groß ist, können diese aber auch schon vor Beginn der Impulssequenz in dem Speicher 21 und 22 gespeichert sein. Unter Umständen kann auf diese zusätzliche Berechnung bzw. Speicherung aber auch verzichtet werden, wenn die Stützstellen der Hüllkurvensignale für den ersten Impuls mit geeignetem Takt ausgelesen werden und mit einem geeigneten Faktor multipliziert werden. Während des ersten und des zweiten Impulses ist das Tor 13 geöffnet und das Tor 14 gesperrt.

Der dritte Impuls ist wiederum ein 90°-Impuls, und sein zeitlicher Abstand gegenüber der Mitte des zweiten Impulses ist gleich dem zeitlichen Abstand der Mitten des ersten und des zweiten Impulses voneinander. Damit dieser dritte Hochfrequenzimpuls die Kernspins in einem Bereich um die Gerade x = x0 und y = y0 in die z-Richtung oder die Gegenrichtung kippen kann, muß die mit den Kernspins mitrotierende Komponente des Magnetfeldes dieses Hochfrequenzimpulses senkrecht zu dem Kernmagnetisierungsvektor in diesem Bereich verlaufen. Dies erfordert also, daß die räumliche Lage der erwähnten Komponente des Magnetfeldes des dritten Hochfrequenzimpulses eingestellt werden kann. Dies ist in einfacher Weise dadurch möglich, daß die Phasenlage des Oszillatorsignals um einen bestimmten Winkel gedreht wird, weil diese Phasendrehung eine gleich große Drehung der Winkellage der mitrotierenden Komponente des durch den dritten Hochfrequenzimpuls erzeugten Magnetfeldes in der xy-Ebene des rotierenden Koordinatensystems zur Folge hat. Aus diesem Grund wird beim dritten Hochfrequenzimpuls die Torschaltung 13 gesperrt und die Torschaltung 14 geöffnet, so daß das Oszillatorsignal durch die Phasenschieberschaltung 25 um einen durch die Steuereinrichtung 23 errechneten und der Phasenschieberschaltung 25 vorgegebenen Winkel $\beta$ gedreht wird.

Der Winkel $\beta$ hängt von den Gradientenfeldern während der Hochfrequenz-Magnetfelder, von den für die frequenzmodulierten Impulse verwendeten Frequenzänderungen pro Zeiteinheit (a in Gleichung (1)), von den Koordinaten des auszuwählenden Ortes, aber auch von der Stärke des Hochfrequenzfeldes insbesondere für den 180°-Impuls ab. Zwar läßt sich die Größe von $\beta$ für eine Kippung der Magnetisierung im interessierenden Bereich in + z-oder -z-Richtung berechnen, doch empfiehlt sich zur praktischen Durchführung eher eine experimentielle Vorgehensweise:

Man gibt nach Beendigung der beschriebenen Sequenz einen amplitudenmodulierten 90°-Impuls in Abwesenheit von Gradientenfeldern und empfängt das hiervon erzeugte Kernspinsignal. Dabei kann der Empfänger (Demodulator) durch Vorexperimente so abgeglichen werden, daß ein aus der + z-Richtung ausgelenkter Magnetisierungsvektor zu einem positiven reellen Signal führt. Wiederholt man nun die beschriebene Sequenz mit dem anschließenden 90°-Impuls und der Signaldetektion für verschiedene Einstellungen von $\beta$, so erhält man eine Abhängigkeit des Signals von dem Wert $\sin(\beta-\beta o)$. Hieraus erhält man die gewünschte Einstellung $\beta = \beta o$ für eine Kippung der Magnetisierung in + z-Richtung bzw. $\beta = \beta o + \pi$ für eine Kippung in -z-Richtung.

Der dritte Impuls kann die gleiche Dauer $T_0$ und die gleiche zeitliche Änderung a der Kreisfrequenz in dem frequenzmodulierten Signal aufweisen wie der erste Impuls. Wenn in diesem Fall auch noch während des dritten Impulses ein Gradientenfeld mit in z-Richtung verlaufendem Gradienten eingeschaltet wird, der genauso groß ist wie der Gradient während des ersten Hochfrequenzimpulses, ergeben sich in z-Richtung die gleichen Abmessungen des selektiv angeregten Teilvolumens wie in x-Richtung. In diesem Fall können auch die gleichen Hüllkurvensignale $s_1(t)$ und $s_2(t)$ benutzt werden wie beim ersten Impuls. Da dann jedoch die Torschaltung 13 gesperrt und die Torschaltung 14 geöffnet ist, wird das Oszillatorsignal durch das Phasendrehglied 25 um den Winkel $\beta$ in der Phase gedreht, so daß am Eingang des Verstärkers 31 ein Signal v(t) anliegt, das von diesem in einen dazu proportionalen Strom durch die Hochfrequenzspule 11 umgesetzt wird und daß der Beziehung genügt

$$v(t) = s_1(t) \cos(w_0 t + \beta) + s_2(t)\sin(w_0 t + \beta) \quad (7).$$

Das Signal v(t) entspricht also bis auf die Phasendrehung des Oszillatorsignals um den Winkel $\beta$ dem Signal u(t), mit dem der Verstärker während des ersten Hochfrequenzimpulses gespeist wird.

Es ist nicht erforderlich, daß das frequenzmodulierte Signal beim dritten Impuls die gleiche Dauer und die gleiche Bandbreite hat wie beim ersten Impuls. Ändert man eine dieser Größen, ohne die Größe des Gradienten des während dieses Impulses wirksamen magnetischen Gradientenfeldes zu ändern, dann können die Abmessungen des anzuregenden Volumens in z-Richtung anders gewählt werden als in x-Richtung. In diesem Fall müßten die Hüllkurvensignale $s_1(t)$ und $s_2(t)$ für den dritten Impuls ebenfalls berechnet werden bzw. schon berechnet im Speicher vorliegen.

Es ist nicht erforderlich, daß die zwischen den Impulsen wirksamen magnetischen Gradientenfelder, die zur Bestimmung der Lage des selektiv anzuregenden Teilvolumens dienen, zwischen dem ersten und dem zweiten Impuls angelegt werden; sie können auch zwischen dem zweiten und dem dritten Impuls angelegt werden. Jedoch müssen die Gradienten dann die entgegengesetzte Polarität haben, damit die gleiche Wirkung erreicht wird wie mit zwischen dem ersten und dem zweiten Impuls wirkenden Gradientenfeldern. Das zur Verschiebung des Teilvolumens in x-Richtung dienende Gradientenfeld müßte also die gleiche Polarität haben wie das während des ersten Impulses wirksame Gradientenfeld und das zur Verschiebung des Teilvolumens in z-Richtung dienende Volumen müßte das entgegengesetzte Vorzeichen haben wie das während des dritten Impulses wirkende Gradientenfeld, wenn die Verschiebung durch diese Gradientenfelder vom Rande in Richtung auf den Koordinatenursprung erfolgen soll.

Um ein Teilvolumen mit vorgebbarer Lage und Größe selektiv anregen zu können, muß der Benutzer über eine nicht näher dargestellte Tastatur der Steuereinrichtung, die einen Microcomputer enthalten muß, Lage und Größe des selektiv anzuregenden Volumens vorgeben. Die Steuereinrichtung 23 bestimmt aus diesen Vorgaben die Hüllkurven für die drei Impulse, die Größe der während und zwischen den Impulsen wirkenden Gradientenfelder und die Phasenverschiebung β und steuert die angeschlossenen Baueinheiten entsprechend.

**Ansprüche**

1. Kernspinuntersuchungsverfahren zur selektiven Anregung eines begrenzten Volumens eines zu untersuchenden Körpers, bei dem der Körper einem homogenen statischen Magnetfeld, drei Sequenzen eines senkrecht zum statischen Magnetfeld verlaufenden Hochfrequenzmagnetfeldes und während wenigstens einer der drei Sequenzen einem in Richtung des statischen Magnetfeldes verlaufenden Gradienten-Magnetfeld ausgesetzt ist,

dadurch gekennzeichnet , daß die erste Sequenz aus einem ersten Impuls besteht, der die Kernmagnetisierung um zumindest annähernd 90° kippt, daß die zweite Sequenz aus einem 180°-Impuls besteht, daß die dritte Sequenz aus einem dritten Impuls besteht, der die Kernmagnetisierung um den gleichen Winkel kippt wie der erste Impuls und dessen Phasenlage so gewählt ist, daß in dem zu selektierenden Volumen die Kernmagnetisierung in die Richtung des statischen Feldes oder in die Gegenrichtung gekippt wird, daß wenigstens der Impuls, währenddessen das Gradientenfeld wirksam ist, frequenzmoduliert ist und daß die Mitte des zweiten Impulses von den Mitten des ersten und des dritten Impulses jeweils den gleichen zeitlichen Abstand hat.

2. Verfahren nach Anspruch 1,

dadurch gekennzeichnet, daß wenigstens zwei der drei Impulse frequenzmoduliert sind, daß während jedes dieser Impulse ein Gradientenfeld wirksam ist und daß die Gradienten dieser Gradientenfelder zueinander senkrecht stehen.

3. Verfahren nach Anspruch 1 oder 2,

dadurch gekennzeichnet, daß zwischen dem ersten und dem zweiten oder dem zweiten und dem dritten Impuls wenigstens ein magnetisches Gradientenfeld wirksam ist.

4. Verfahren nach Anspruch 3,

dadurch gekennzeichnet, daß das bzw. die zwischen den Impulsen wirksamen magnetischen Gradientenfeld(er) einen Gradienten in der gleichen Richtung, jedoch mit entgegengesetzter Polarität aufweist, wie das Gradientenfeld, das während eines der drei Impulse wirksam ist.

5. Verfahren nach einem der Ansprüche 1 bis 4,

dadurch gekennzeichnet, daß die Größe der Gradienten der magnetischen Gradientenfelder einstellbar sind.

6. Anordnung zur Durchführung des Verfahrens nach Anspruch 1 mit einem Magneten (1) zur Erzeugung eines statischen homogenen Magnetfeldes, drei Spulenanordnungen (3, 5, 7) zur Erzeugung von Gradienten-Magnetfeldern, die in Richtung des statischen Magnetfeldes verlaufen und deren Gradienten in drei zueinander senkrechten Richtungen verlaufen, und mit einer Hochfrequenzspule (11) zur Erzeugung von Hochfrequenz-Magnetfeldern, die zur Richtung des statischen Magnetfeldes senkrecht verlaufen, sowie mit Steuermitteln zum Aktivieren der Spulenanordnungen und der Hochfrequenz-Spulenanordnung,

dadurch gekennzeichnet, daß mit der Hochfrequenz-Spulenanordnung (11) ein FM-Modulator (12...17) gekoppelt ist und daß die Steuereinrichtung (23) die Hochfrequenz-Spulenanordnung - (11) und wenigstens eine der drei Spulenanordnungen (3, 5, 7) so steuert, daß während wenigstens eines Hochfrequenzimpulses eine der drei Spulenanordnungen (3, 5, 7) wirksam ist.

7. Anordnung nach Anspruch 6,

dadurch gekennzeichnet, daß der Frequenzmodulator einen Oszillator enthält, der eine Oszillatorschwigung mit der Larmorfrequenz erzeugt, daß der Oszillator mit einer ersten Mischstufe (15) und über einen 90°-Phasenschieber (17) mit einer zweiten Mischstufe (16) gekoppelt ist, und daß die Oszillatorschwingung in den beiden Mischstufen mit Hüllkurvensignalen multipliziert werden, die so gewählt sind, daß die Summe der Ausgangssignale einer linear frequenzmodulierten Schwingung entspricht.

8. Anordnung nach Anspruch 6 oder 7,

dadurch gekennzeichnet, daß ein Phasendrehglied (25) mit einstellbarer Phasendrehung vorgesehen ist.

# FIG.1

FIG.2

FIG.3a

FIG.3b

FIG.3c

FIG.3d

FIG.4a

FIG.4b

FIG.4c

FIG.4d

FIG. 4e

FIG.4f